Europäisches Patentamt

European Patent Office

Office européen des brevets

(19)

(11) Numéro de publication: **0 369 868**
**A1**

## (12) DEMANDE DE BREVET EUROPEEN

(21) Numéro de dépôt: **89403112.9**

(51) Int. Cl.5: **G01R 15/12**

(22) Date de dépôt: **10.11.89**

(30) Priorité: **15.11.88 FR 8814808**

(43) Date de publication de la demande:
**23.05.90 Bulletin 90/21**

(84) Etats contractants désignés:
**DE FR GB IT NL**

(71) Demandeur: **ITT COMPOSANTS ET INSTRUMENTS**
**157, rue des Blains**
**F-92220 Bagneux (Hautes de Seine)(FR)**

(72) Inventeur: **Szoboszlai, Istvan**
**Chemin de la Vieille Route des Pensières**
**74920 Veyrier du Lac(FR)**
Inventeur: **Pierrejean, Didier**
**Le Beau Site, Route du col de Leschaux**
**74320 Sevrier(FR)**
Inventeur: **Ernoult, Frédéric**
**56 rue de Malaz**
**74600 Seynod(FR)**

(74) Mandataire: **Obolensky, Michel et al**
**c/o CABINET LAVOIX 2, place d'Estienne d'Orves**
**F-75441 Paris Cédex 09(FR)**

(54) **Appareil de mesure simultanée d'au moins deux grandeurs électriques.**

(57) Appareil de mesure de différentes grandeurs électriques comprenant une première voie de mesure (1), des moyens (4,6) de sélection d'une grandeur à mesurer par ladite voie et des moyens d'affichage de la grandeur mesurée, caractérisé en ce qu'il comporte au moins une voie supplémentaire (2) de mesure simultanée d'une grandeur électrique différente de celle mesurée par la première voie et des moyens d'affichage destinés à afficher la valeur de la grandeur mesurée par ladite voie de mesure supplémentaire simultanément à l'affichage de la grandeur mesurée par la première voie (1),un microprocesseur (16) étant associé auxdites voies de mesure (1,2), aux moyens de sélection de grandeurs (4,6,10,12) à mesurer et aux moyens d'affichage pour assurer la lecture des signaux de sortie des voies de mesure et la commande de l'affichage des valeurs des grandeurs mesurées sur lesdits moyens d'affichage.

FIG.1

## Appareil de mesure simultanée d'au moins deux grandeurs électriques.

La présente invention concerne les appareils de mesure de grandeurs électriques, à fonctions multiples appelés couramment multimètres.

On connaît des appareils de ce type qui permettent de mesurer différents types de grandeurs électriques et qui comportent à cet effet des moyens de sélection de mode de fonctionnement, par exemple en voltmètre continu, en voltmètre alternatif, en ampèremètre, en fréquencemètre ou autre.

Cependant, il peut être intéressant dans certains cas de connaître simultanément la valeur de deux grandeurs électriques contenues dans un signal à mesurer.

L'invention vise à réaliser un multimètre qui soit capable d'assurer de telles mesures simultanées.

Elle a donc pour objet un appareil de mesure de différentes grandeurs électriques comprenant une première voie de mesure , des moyens de sélection d'une grandeur à mesurer par ladite voie et des moyens d'affichage de la grandeur mesurée, caractérisé en ce qu'il comporte au moins une voie supplémentaire de mesure simultanée d'une grandeur électrique différente de celle mesurée par la première voie et des moyens d'affichage destinés à afficher la valeur de la grandeur mesurée par ladite voie de mesure supplémentaire simultanément à l'affichage de la grandeur mesurée par la première voie, un microproceseur étant associé auxdites voies de mesure, aux moyens de sélection de grandeurs à mesurer et aux moyens d'affichage pour assurer la lecture des signaux de sortie des voies de mesure et la commande de l'affichage des valeurs des grandeurs mesurées sur lesdits moyens d'affichage.

L'invention sera mieux comprise à l'aide de la description qui va suivre, donnée uniquement à titre d'exemple et faite en se référant aux dessins annexés, sur lesquels

- la Fig.1 est un schéma synoptique de l'appareil de mesure suivant l'invention;

- la Fig.2 est une vue en élévation à plus grande échelle de l'afficheur à cristaux liquides entrant dans la construction de l'appareil de mesure suivant l'invention;

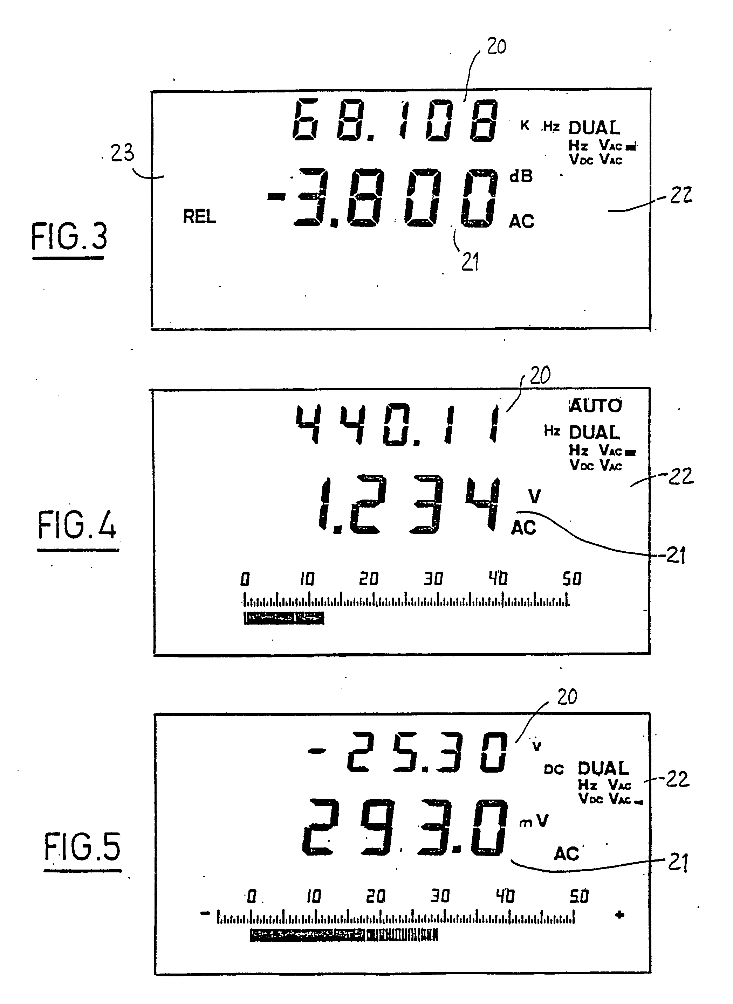

- la Fig.3 est une vue analogue à celle de la Fig.2 représentant l'afficheur sur lequel apparaît la fréquence d'un signal. et son atténuation;

- la Fig.4 est une vue analogue à celle de la Fig.3 représentant l'afficheur sur lequel apparaît la fréquence d'un signal et sa tension;

- la Fig.5 montre l'afficheur sur lequel apparaît la valeur d'une·tension continue et l'ondulation en tension alternative de celle-ci; et

- la Fig.6 est un graphique illustrant la mesure de cos $\phi$ par l'appareil suivant l'invention.

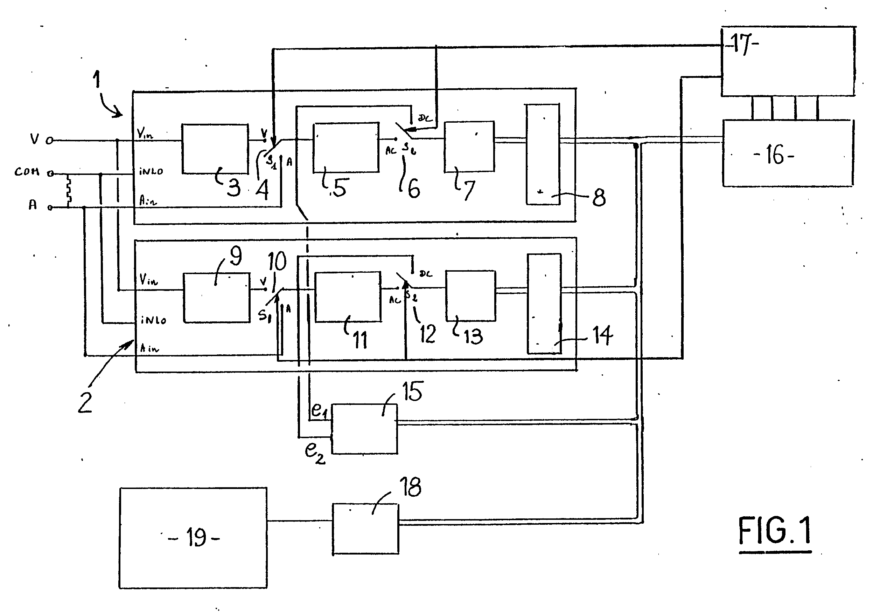

Le circuit de l'appareil suivant l'invention représenté à la Fig.1 comporte une borne d'entrée V de tension, une borne d'entrée A d'intensité et une borne commune COM.

Ces bornes sont respectivement connectées à deux voies 1 et 2 de l'appareil.

La voie 1 appelée également convertisseur 1 est affectée principalement aux mesures de grandeurs alternatives.

La voie 2 appelée également convertisseur 2 est affectée principalement à la mesure de grandeurs continues.

Le convertisseur 1 comporte un atténuateur 3 d'entrée destiné à rendre compatible le niveau du s gnal à mesurer avec la dynamique de la voie de mesure considérée.

A sa sortie, l'atténuateur 3 est connecté par l'intermédiaire d'un premier commutateur 4 à l'entrée d'un convertisseur AC/DC 5 de tension alternative en tension continue.

La borne d'entrée A de l'appareil est connectée directement à un contact fixe du commutateur 4.

La sortie AC du convertisseur 5 est connectée par l'intermédiaire d'un second commutateur 6 à l'entrée d'un convertisseur analogique-numérique 7. Un contact fixe DC du commutateur 6 est connecté à l'entrée du convertisseur AC/DC 6.

La sortie de celui-ci est reliée à des registres d'entrée-sortie 8.

La seconde voie 2 comporte de façon similaire un atténuateur 9, un premier commutateur 10, un convertisseur AC/DC 11, un second commutateur 12, un convertisseur analogique-numérique 13 et des registres d'entrée-sortie 14 connectés de la même façon que les constituants correspondants de la première voie 1.

En outre, les entrées des convertisseurs AC/DC 5 et 11 des deux voies sont connectées respectivement à une entrée e1, e2 d'un fréquencemètre 15.

Les registres d'entrée-sortie 8, 14 et le fréquencemètre 15 sont reliés à un microprocesseur de gestion 16 commandé par un clavier 17 qui assure également la commande des commutateurs 4,6 et 10, 12 des premières et secondes voies 1 et 2.

Le microprocesseur est relié par l'intermédiaire d'un circuit d'attaque 18 à un afficheur·numérique 19 tel qu'un afficheur à cristaux liquides.

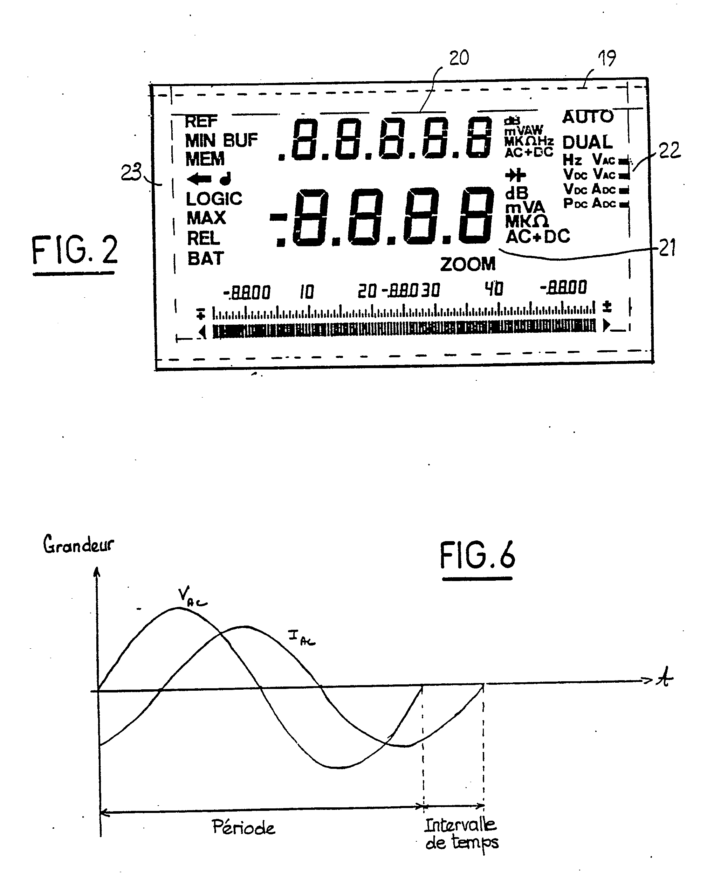

Comme représenté à la Fig.2, l'afficheur 19 est un afficheur double présentant deux zones d'affi chage 20 et 21 destinées à pouvoir présenter simultanément deux valeurs indépendantes. Par ailleurs, il comporte de nombreux indicateurs 22 et 23 qui sont tous représentés sur la Fig.2 et qui sont destinés à indiquer respectivement les grandeurs mesurées et le mode de fonctionnement de l'appareil.

Dans l'exemple considéré,le convertisseur 1 ou de courant alternatif présente une impédance de 1 MΩ.

Son atténuateur d'entrée 3 permet de rendre le niveau du signal d'entrée compatible avec la dynamique du convertisseur analogique-numérique 7.

Il permet à l'aide des commutateurs 4 et 6 de sélectionner soit l'entrée de tension, soit l'entrée de courant.

Son convertisseur analogique-numèrique 7 fournit un code binaire représentatif du signal analogique mesure.

Ses registres d'entrée-sortie 8 sont adressés par le microprocesseur 16.

Ils permettent de sélectionner le mode de fonctionnement et de lire les résultats du convertisseur 7.

Les registres de commande 8,14 permettent en particulier de sélectionner, par l'intermédiaire de l'atténuateur d'entrée 3, la bonne gamme de mesure.

Le convertisseur 2 ou de courant continu possède une impédance d'entrée de 10 MΩ. Pour le reste, les propriétés de ses constituants sont les mêmes que celles des constituants correspondants du convertisseur 1.

Le convertisseur 1 a une impédance d'entrée plus faible que le convertisseur 2 afin d'obtenir une meilleure bande passante pour les mesures de tensions alternatives.

Le fréquencemètre 15 comporte la même inter-face de liaison 16 que les convertisseurs 7 et 13.

Il permet de mesurer la fréquence du signal sur chacune de ses entrées e1 et e2 et de mesurer l'intervalle de temps entre deux fronts d'onde des signaux appliqués aux entrées e1 et e2.

Le microproceseur 16 assure la gestion des deux voies de l'appareil et notamment la mise à l'échelle en fonction de la grandeur mesurée.

Il effectue des calculs éventuels et envoie les résultats vers le circuit d'attaque 18 de l'afficheur à cristaux liquides 19.

Le circuit d'attaque 18 commande l'afficheur 19 qui est du type alphanumérique. Il génère en outre les tensions de commande de l'afficheur.

L'afficheur à cristaux liquides 19 permet de visualiser les résultats des mesures.

Selon le mode de fonctionnement choisi,les convertisseurs ou voies 1 et 2 et le fréquencemètre sont mis à contribution par le microprocesseur 16 d'une manière représentée dans le tableau suivant.

| Fonction sélectionnée | Mesure faite par | | |
| --- | --- | --- | --- |
| | Convertisseur AC 1 | Convertisseur DC 2 | Fréquence-mètre 15 |
| Hz - Vac fréquence-tension alternative | Tension alternative | | Fréquence |
| Vdc - Vac tension continue tension alternative | Tension alternative | Tension continue | |
| Vdc - Idc tension et courant continu | Courant continu | Tension continue | |
| Vac - Iac tension et courant alternatif | Tension alternative | Courant alternatif | |
| Wdc - Idc puissance et courant continu | Courant continu | Tension continue | |
| Wac - Iac | Tension alternative | Courant alternatif | 1-Période 2-intervalle de temps |

Dans le cas des mesures de puissance, le microprocesseur 16 effectue les calculs :

Wdc = Vdc x Idc

Wac = Vac x Iac x Cos (valable pour des signaux sinusoïdaux).

Le cosinus $\phi$ est obtenu par calcul après mesure de la période du signal et de l'intervalle de temps entre le passage par zéro de la tension et le passage par O du courant (Fig.6).

Si le convertisseur 1 fait une mesure de tension, le commutateur 4 est positionné sur V.

Pour une mesure de courant, le commutateur 4 est positionné sur A.

Pour une mesure en courant continu, le commutateur 6 est positionné sur DC.

Pour une mesure en courant alternatif, le commutateur 6 est positionné sur AC.

Les positions des comutateurs sont commandées par le clavier 17 associé au microprocesseur 16.

Les mêmes positions sont occupées par les commutateurs 10 et 12 lorsque des mesures correspondantes sont effectuées par le convertisseur 2.

A la fin de chaque mesure, le convertisseur 1 ou 2 transmet la valeur mesurée et le microprocesseur 16 détermine si la gamme est correcte et positionne les registres de commande 8, 14 en conséquence.

Les résultats des mesures sont simultanés car les deux convertisseurs 1 et 2 sont synchronisés et présentent leur résultat au même instant. Le microprocesseur 16 lit les résultats séquentiellement.

Dans l'exemple qui vient d'être décrit, l'appareil de mesure suivant l'invention est un appareil à deux voies de mesure. On peut cependant réaliser des appareils de mesure présentant trois voies ou plus de mesure simultanée de grandeurs différentes commandées par microprocesseur.

**Revendications**

1. Appareil de mesure de différentes grandeurs électriques comprenant une première voie de mesure (1), des moyens (4,6) de sélection d'une grandeur à mesurer par ladite voie et des moyens d'affichage (20) de la grandeur mesurée, caractérisé en ce qu'il comporte au moins une voie supplémentaire (2) de mesure simultanée d'une grandeur électrique différente de celle mesurée par la première voie et des moyens d'affichage (21) destinés à afficher la valeur de la grandeur mesurée par ladite voie de mesure supplémentaire simultanément à l'affichage de la grandeur mesurée par la première voie (1),un microproceseur (16) étant associé auxdites voies de mesure ( 1,2), aux moyens de sélection de grandeurs (4,6,10, 12) à mesurer et aux moyens d'affichage (20,21) pour assurer la lecture des signaux de sortie des voies de mesure et la commande de l'affichage des valeurs des grandeurs mesurées sur lesdits moyens d'affichage.

2. Appareil de mesure suivant la revendication 1, caractérisé en ce que chacune des voies de mesure comporte un atténuateur d'entrée (3,9) connecté par l'intermédiaire d'un premier commutateur de sélection (4,10) soit à l'entrée d'un convertisseur AC/DC (5, 11), la sortie de celui-ci étant connectée par l'intermédiaire d'un second commutateur à un convertisseur analogique-numérique (7,13),soit directement à l'entrée du convertisseur analogique-numérique, ce dernier étant relié à des registres d'entrée/sortie (8,14) auxquels est connecté le microprocesseur (16), un fréquencemètre également commandé par le microprocesseur (16) comportant deux entrées (e1, e2) connectées respectivement aux entrées des convertisseurs (AC/DC) (5,11) de la première voie de mesure (1) et de la voie de mesure supplémentaire (2).

FIG.1

EP 0 369 868 A1

FIG. 2

REF
MIN BUF
MEM
LOGIC
MAX
REL
BAT

dB
mVAW
MKΩHz
AC+DC

AUTO
DUAL
Hz  V_AC
V_DC  V_AC
V_DC  A_DC
P_DC  A_DC

dB
mVA
MKΩ
AC+DC

ZOOM

FIG. 6

Grandeur

V_AC

I_AC

t

Période

Intervalle
de temps

FIG.3

```
68.108  K Hz DUAL
              Hz VAC
              VDC VAC
        -3.800 dB
   REL          AC
```
20, 21, 22, 23

FIG.4

```
440.11  AUTO
              Hz DUAL
              Hz VAC
              VDC VAC
        1.234  V
               AC

0   10   20   30   40   50
```
20, 21, 22

FIG.5

```
-25.30  V
              DC DUAL
              Hz VAC
              VDC VAC
        293.0  mV
               AC

0   10   20   30   40   50
-                              +
```
20, 21, 22

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | ELEKTRONIK, Vol. 35, no 8, 18 avril 1986, pages 126-130, Munich, DE; "Messplatz für die Westentasche" * Figures 2,3-6; page 129, dernier alinéa, page 130, dernier alinéa * --- | 1 | G 01 R  15/12 |
| Y | IDEM --- | 2 | |
| Y | GB-A-2 055 480  (Sangamo Weston) * Page 2, lignes 18-47; résumé; figure 1 * --- | 2 | |
| A | GB-A-2 194 348  (FLUKE) * En entier * --- | 1,2 | |
| A | DE-A-3 035 167  (Metz) * Page 6, alinéa 1; page 11, dernier alinéa; figures 2,3 * --- | 1 | |
| A | EP-A-0 157 135  (BBC) * Page 9, lignes 17-23; page 14, ligne 21 - page 15, ligne 16; résumé; figures 1,3 * ----- | 1,2 | DOMAINES TECHNIQUES RECHERCHES (Int. Cl.5) G 01 D G 01 R |

Le présent rapport a été établi pour toutes les revendications

| Lieu de la recherche | Date d'achèvement de la recherche | Examinateur |
|---|---|---|
| LA HAYE | 15-01-1990 | LUT K. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

........................................................

& : membre de la même famille, document correspondant

EPO FORM 1503 03.82 (P0402)